# EUROPEAN PATENT APPLICATION

(11) **EP 4 827 000 A1**
(43) Date of publication of application: **21.10.2026**
(21) Application number: 25738320.8
(22) Date of filing: 03.01.2025
(51) Int. Cl.: H03M 13/11

(54) **ENCODING METHOD AND APPARATUS, AND DECODING METHOD AND APPARATUS**

(30) Priority: 09.01.2024 CN 202410035730
(71) Applicant: Huawei Technologies Co., Ltd., Shenzhen, Guangdong 518129 (CN)
(72) Inventor: QIN, Kangjian, Shenzhen, Guangdong 518129 (CN); ZHANG, Huazi, Shenzhen, Guangdong 518129 (CN); LIU, Ke, Shenzhen, Guangdong 518129 (CN); WANG, Xianbin, Shenzhen, Guangdong 518129 (CN); TONG, Jiajie, Shenzhen, Guangdong 518129 (CN); WANG, Jun, Shenzhen, Guangdong 518129 (CN)
(74) Representative: Maiwald GmbH
(86) International application number: PCT/CN2025/070360
(87) International publication number: WO 2025/148789

(57) **Abstract**

This application relates to an encoding method, a decoding method, and an apparatus. In the encoding method, a first device may determine a second bit sequence and a third bit sequence based on a first bit sequence, where the third bit sequence includes a bit sequence whose weight is higher than a first threshold in a base graph corresponding to the first bit sequence. In other words, a weight corresponding to the second bit sequence is lower than a weight corresponding to the third bit sequence. Further, the first device may perform polar code encoding on the second bit sequence, to provide additional protection for the second bit sequence having a lower weight in a polar code encoding manner, so as to improve error correction performance. LDPC encoding may be performed on the third bit sequence having a higher weight together with a polar code encoding result (that is, a fourth bit sequence obtained by performing polar code encoding on the second bit sequence). This reduces an error floor in LDPC decoding and improves error correction performance of an LDPC code.

## Description

This application claims priority to Chinese Patent Application No. 202410035730.9, filed with the China National Intellectual Property Administration on January 9, 2024, and entitled "ENCODING METHOD, DECODING METHOD, AND APPARATUS", which is incorporated herein by reference in its entirety.

### TECHNICAL FIELD

This application relates to the field of communication technologies, and in particular, to an encoding method, a decoding method, and an apparatus.

### BACKGROUND

Low-density parity-check (low-density parity-check, LDPC) codes are a channel coding scheme that approaches the Shannon limit very close, and is characterized by good performance, low complexity, and the like. LDPC codes have been adopted by the 3rd generation partnership project (3rd generation partnership project, 3GPP) as a data channel coding scheme for the 5th generation (the fifth generation, 5G) communication technology.

However, when a signal-to-noise ratio (signal-to-noise ratio, SNR) is relatively high, an LDPC code may exhibit an error floor (error floor) due to the influence of trapping sets, and a block error rate (block error rate, BLER) of the LDPC code no longer decreases as the signal-to-noise ratio increases. A trapping set is a set of bit indices for which correct decoding output still cannot be obtained after a relatively large fixed number of iterations, and the error floor is mainly determined by the size and distribution of the trapping sets. Therefore, how to reduce the error floor of LDPC codes has become an urgent problem to be resolved in a current phase.

### SUMMARY

This application provides an encoding method, a decoding method, and an apparatus. This reduces an error floor and a block error rate of an LDPC code and improves error correction performance.

According to a first aspect, an encoding method is provided. The method may be performed by a first device, may be performed by a module (for example, a processor, a chip, or a chip system) used in the first device, or may be implemented by a logical node, a logical module, or software that can implement all or some functions of the first device. In the encoding method, a second bit sequence and a third bit sequence may be determined based on a first bit sequence, where the third bit sequence includes a bit sequence whose weight is higher than a first threshold in a base graph corresponding to the first bit sequence. Alternatively, polar code encoding may be performed on the second bit sequence to obtain a fourth bit sequence. Therefore, low-density parity-check LDPC encoding may be performed on the third bit sequence and the fourth bit sequence to obtain a fifth bit sequence.

It can be learned that, in the foregoing embodiment, the first device may determine the second bit sequence and the third bit sequence based on the first bit sequence, where the third bit sequence includes the bit sequence whose weight is higher than the first threshold in the base graph corresponding to the first bit sequence. In other words, a weight corresponding to the second bit sequence is lower than a weight corresponding to the third bit sequence. Further, the first device may perform polar code encoding on the second bit sequence, to provide additional protection for the second bit sequence having a lower weight in a polar code encoding manner, so as to improve error correction performance. LDPC encoding may be performed on the third bit sequence having a higher weight together with a polar code encoding result (that is, the fourth bit sequence obtained by performing polar code encoding on the second bit sequence). In this way, an error floor in LDPC decoding can be reduced, and error correction performance of an LDPC code can be improved. In addition, LDPC encoding payload caused by polar outer code encoding can be further reduced, to reduce a code rate of the LDPC code and improve waterfall region performance.

In a possible implementation, the determining the second bit sequence and the third bit sequence based on the first bit sequence includes: determining a first value based on a first quantity of columns whose weight is higher than the first threshold in the base graph; determining the third bit sequence from the first bit sequence based on the first value and a lifting factor corresponding to the first bit sequence; and determining the second bit sequence based on the third bit sequence and the first bit sequence.

It can be learned that, in the foregoing embodiment, the first device may determine the first value based on the first quantity of columns whose weight is higher than the first threshold in the base graph, so that the third bit sequence can be determined from the first bit sequence based on the first value and the lifting factor corresponding to the first bit sequence. In this way, a bit sequence having a large column weight in the first bit sequence can be more accurately determined, and a bit sequence having a column weight that is not large, that is, the second bit sequence, can be more accurately determined.

In a possible implementation, the first quantity of columns is an integer greater than or equal to 1. For example, the first quantity of columns may be 2 or 3.

In a possible implementation, the determining the first value based on the first quantity of columns whose weight is higher than the first threshold in the base graph includes: determining a second quantity of columns having highest reliability from columns other than the columns whose weights are higher than the first threshold in the base graph; and determining the first value based on the first quantity of columns and the second quantity of columns.

It can be learned that, in the foregoing embodiment, the first device may further determine the first value based on the first quantity of columns and the second quantity of columns. The first value may be used to determine the third bit sequence from the first bit sequence, to increase a quantity of bits on which polar code encoding is not performed. Therefore, this can reduce LDPC encoding payload caused by polar outer code encoding, to reduce a code rate of the LDPC code and improve waterfall region performance.

In a possible implementation, the performing polar code encoding on the second bit sequence to obtain the fourth bit sequence includes: performing check coding on the second bit sequence to obtain a sixth bit sequence; and performing polar code encoding on the sixth bit sequence to obtain the fourth bit sequence. The check coding may be parity check (parity check, PC) encoding and/or cyclic redundancy check (cyclic redundancy check, CRC) encoding.

It can be learned that, in the foregoing embodiment, the first device may first perform check coding on the second bit sequence, and then perform polar code encoding. It is equivalent to that a check code checks only bits having column weights that are not large. This is because bits having large column weights almost do not have an error. If an error occurs, the bits having the column weights that are not large are also very likely to have an error, and error correction may be performed on the bits having the column weights that are not large by using the check code. In addition, the check code may be used for error correction, so that performance of a polar code in SCL decoding can be improved when SCL decoding is used.

In a possible implementation, the method further includes: performing check coding on a seventh bit sequence to obtain the first bit sequence.

It can be learned that, in the foregoing embodiment, the first device may perform check coding on the seventh bit sequence to obtain the first bit sequence. The seventh bit sequence includes bits having large column weights. In other words, the bits having the large column weights can also be checked by the check code, to obtain a lower false alarm rate (false alarm rate, FAR).

In a possible implementation, the method further includes: segmenting an initial bit sequence based on a first segment length to obtain X bit sequences, where the X bit sequences include the first bit sequence or the seventh bit sequence, and X is an integer greater than 1, where the first segment length is determined based on the first value and the lifting factor.

It can be learned that, in the foregoing embodiment, the first device may segment the initial bit sequence based on the first segment length, where the first segment length is determined based on the first value and the lifting factor. In other words, this provides a segmentation manner that is applicable to this solution, which reduces an encoding error problem caused by a segmentation error.

In a possible implementation, that the first segment length is determined based on the first value and the lifting factor includes: the first segment length is determined based on the first value, the lifting factor, and a second value, where the second value is determined based on a total quantity of columns in the base graph and the first value.

In a possible implementation, the first segment length meets the following condition: $K 1 = \left⌈\left(a+b\times R\right)\times Z\right⌉$, where a is the first value, b is the second value, R is a third value, and Z is the lifting factor.

In a possible implementation, the determining the second bit sequence based on the third bit sequence and the first bit sequence includes: segmenting, based on a second segment length, a bit sequence other than the third bit sequence in the first bit sequence, to obtain Y bit sequences, where the Y bit sequences include the second bit sequence, and Y is an integer greater than 1, where the second segment length is determined based on a maximum length supported by polar code encoding and the third value.

It can be learned that, in the foregoing embodiment, the first device may segment, based on the second segment length (which is determined based on the maximum length supported by polar code encoding and the third value), the bit sequence other than the third bit sequence in the first bit sequence, to obtain the Y bit sequences, where the Y bit sequences may include the second bit sequence. In this way, no error occurs when polar code encoding is performed on the second bit sequence, and a current polar code manner is better compatible.

In a possible implementation, the second segmentation length meets the following condition: $K 2 = \left⌈Nm\times R\right⌉$, where Nm is the maximum length supported by polar code encoding, and R is the third value.

In a possible implementation, the method further includes: sending a symbol sequence based on the third bit sequence.

According to a second aspect, a decoding method is provided. The method may be performed by a second device, may be performed by a module (for example, a processor, a chip, or a chip system) used in the second device, or may be implemented by a logical node, a logical module, or software that can implement all or some functions of the second device. In the decoding method, a symbol sequence may be obtained, so that a fifth bit sequence may be determined based on the symbol sequence, and LDPC decoding is performed on the fifth bit sequence to obtain a third bit sequence and a fourth bit sequence. In this way, polar code decoding may be performed on the fourth bit sequence to obtain a second bit sequence, and a first bit sequence is determined based on the third bit sequence and the second bit sequence.

It can be learned that, in the foregoing embodiment, the second device may first determine the fifth bit sequence based on the symbol sequence, and then perform LDPC decoding on the fifth bit sequence to obtain the third bit sequence and the fourth bit sequence, so that polar code decoding can be performed on the fourth bit sequence to obtain the second bit sequence. In this way, the first bit sequence may be determined based on the third bit sequence and the second bit sequence. This can reduce an error floor in LDPC decoding, thereby improving error correction performance of an LDPC code. In addition, LDPC encoding payload caused by polar outer code encoding can be further reduced, to reduce a code rate of the LDPC code and improve waterfall region performance. In addition, the second device performs polar code decoding on a part of bit sequences (for example, the fourth bit sequence) in an LDPC decoding result, a decoding delay is reduced and decoding efficiency is improved.

According to a third aspect, a communication apparatus is provided, including a unit or a module configured to implement the method according to any one of the implementations in the first aspect to the second aspect. The communication apparatus may be a first device or a second device, may be a module (for example, a processor, a chip, or a chip system) of the first device or the second device, or may be a logical node, a logical module, or software that can implement all or some functions of the first device or the second device.

According to a fourth aspect, a communication apparatus is provided. The communication apparatus includes at least one processor. The at least one processor is configured to perform the method according to any one of the implementations in the first aspect to the second aspect. The communication apparatus may be a first device or a second device, may be a module (for example, a processor, a chip, or a chip system) of the first device or the second device, or may be a logical node, a logical module, or software that can implement all or some functions of the first device or the second device. The at least one processor may execute a computer program or instructions in a memory, to enable execution of the foregoing method. The memory may be included in the communication apparatus, or may be located outside the communication apparatus. In addition, the communication apparatus may further include an interface.

According to a fifth aspect, a communication system is provided. The communication system includes a first device and a second device. The first device is configured to perform the method according to any one of the implementations of the first aspect. The second device is configured to perform the method according to any one of the implementations in the second aspect.

According to a sixth aspect, a computer-readable storage medium is provided. The computer-readable storage medium stores computer instructions. When the computer instructions are executed, a computer is caused to perform the method according to any one of the implementations in the first aspect to the second aspect.

According to a seventh aspect, a computer program product is provided. The computer program product includes computer program code. When the computer program code is executed by a computer, the computer is caused to perform the method according to any one of the implementations in the first aspect to the second aspect.

### BRIEF DESCRIPTION OF DRAWINGS

FIG. 1 shows a basic architecture of a communication system according to an embodiment of this application;
FIG. 2 is a diagram of a communication process between communication devices;
FIG. 3 is a diagram of polar code encoding;
FIG. 4 is a diagram of a check matrix;
FIG. 5 is a schematic flowchart of an encoding method according to an embodiment of this application;
FIG. 6 is a schematic flowchart of a decoding method according to an embodiment of this application;
FIG. 7 is a schematic flowchart of another encoding method according to an embodiment of this application;
FIG. 8 is a schematic flowchart of another decoding method according to an embodiment of this application;
FIG. 9 is an example of encoding and decoding according to an embodiment of this application;
FIG. 10A and FIG. 10B are comparison diagrams of beneficial effects according to an embodiment of this application;
FIG. 11 is another example of encoding and decoding according to an embodiment of this application;
FIG. 12A to FIG. 12D are other comparison diagrams of beneficial effects according to an embodiment of this application;
FIG. 13 is a diagram of a structure of a communication apparatus according to an embodiment of this application; and
FIG. 14 is a diagram of a structure of another communication apparatus according to an embodiment of this application.

### DESCRIPTION OF EMBODIMENTS

The following describes the technical solutions in embodiments of this application with reference to the accompanying drawings in embodiments of this application. The terms "system" and "network" may be used interchangeably in embodiments of this application. Unless otherwise specified, "/" represents an "or" relationship between associated objects. For example, A/B may represent A or B. The term "and/or" in this application is merely an association relationship for describing associated objects, and represents that three relationships may exist. For example, A and/or B may represent the following three cases: Only A exists, both A and B exist, and only B exists, where A and B may be singular or plural. In addition, in the descriptions of this application, unless otherwise specified, "a plurality of" means two or more. "At least one of the following items (pieces)" or a similar expression thereof indicates any combination of these items, including a single item (piece) or any combination of a plurality of items (pieces). For example, at least one item (piece) of a, b, or c may indicate a, b, c, a and b, a and c, b and c, or a, b, and c, where a, b, and c may be singular or plural. In addition, to clearly describe the technical solutions in embodiments of this application, the terms such as "first" and "second" are used in embodiments of this application to distinguish between network elements and between same items or similar items that have basically same functions. A person skilled in the art may understand that the terms such as "first" and "second" do not limit a quantity or an execution sequence, and the terms such as "first" and "second" do not indicate a definite difference.

Reference to "an embodiment", "some embodiments", or the like described in embodiments of this application means that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "comprise", "include", "have", and their variants all mean "include but are not limited to", unless otherwise specifically emphasized in another manner.

In the following specific implementations, the objectives, technical solutions, and beneficial effects of this application are further described in detail. It should be understood that the following descriptions are merely specific implementations of this application, but are not intended to limit the protection scope of this application. Any modification, equivalent replacement, improvement, or the like made based on the technical solutions of this application shall fall within the protection scope of this application.

In embodiments of this application, unless otherwise stated or there is a logic conflict, terms and/or descriptions in different embodiments are consistent and may be mutually referenced, and technical features in different embodiments may be combined into a new embodiment based on an internal logical relationship thereof.

It should be understood that the technical solutions in embodiments of this application may be applied to a long term evolution (long term evolution, LTE) architecture, a 5th generation mobile communication technology (5th generation mobile networks, 5G), a wireless local area network (wireless local area network, WLAN) system, a vehicle-to-everything (vehicle-to-everything, V2X) communication system, LTE-vehicle (LTE-vehicle, LTE-V), vehicle-to-vehicle (vehicle-to-vehicle, V2V), internet of vehicles, machine type communication (machine type communications, MTC), and the like. The technical solutions in embodiments of this application may be further applied to another future communication system, for example, a 6G communication system. In a future communication system, a same function may be maintained, but a name may be changed.

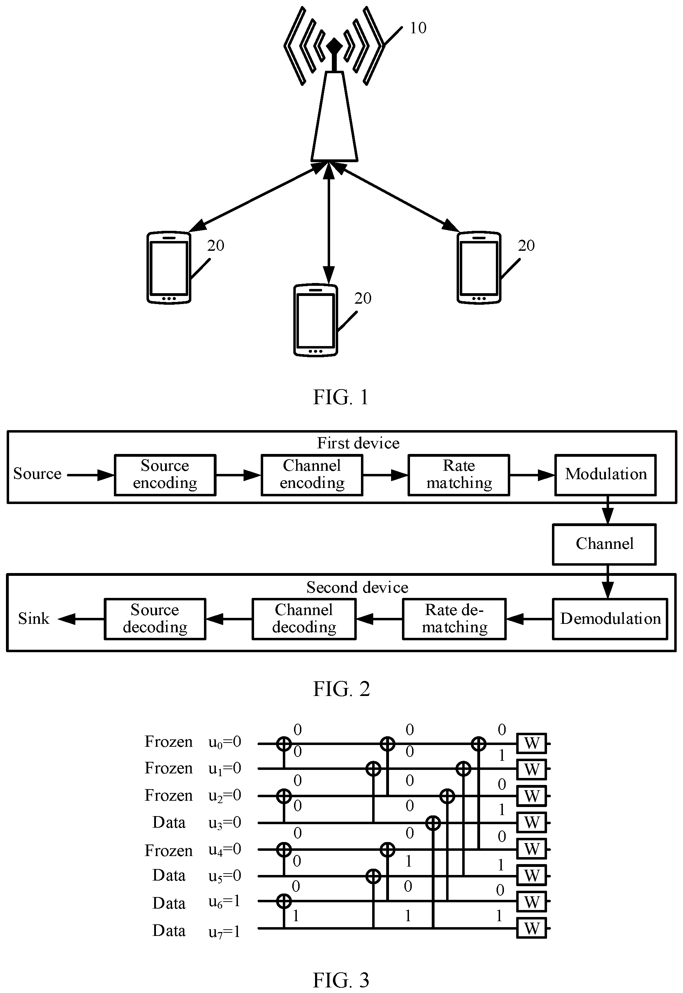

The following describes a basic architecture of a communication system provided in embodiments of this application. The communication system provided in this application may include one or more network devices and one or more terminal devices. The following uses a system architecture shown in FIG. 1 as an example for description. As shown in FIG. 1, the communication system includes a network device 10 and one or more terminal devices (for example, terminal devices 20 in FIG. 1) communicating with the network device 10.

It should be noted that quantities of network devices and terminal devices in FIG. 1 are merely examples, which should not be considered as any limitation on this application. The following further describes in detail devices in the system architecture.

### 1. Terminal device

The terminal device is an entity on a user side for signal reception, signal transmission, or signal transmission and reception. The terminal device is configured to provide one or more of a voice service and a data connectivity service for users. The terminal device may be a device that includes a wireless transceiver function and that can cooperate with the network device to provide a communication service for users. Specifically, the terminal device may refer to user equipment (user equipment, UE), an access terminal, a subscriber unit, a subscriber station, a mobile station, a remote station, a remote terminal, a mobile device, a terminal, a wireless communication device, a user agent, a user apparatus, or a road side unit (road side unit, RSU). The terminal device may alternatively be an uncrewed aerial vehicle, an internet of things (internet of things, IoT) device, a station (station, ST) in a wireless local area network (wireless local area network, WLAN), a cellular phone (cellular phone), a smartphone (smartphone), a cordless phone, a wireless data card, a tablet computer, a session initiation protocol (session initiation protocol, SIP) phone, a wireless local loop (wireless local loop, WLL) station, a personal digital assistant (personal digital assistant, PDA) device, a laptop computer (laptop computer), a machine type communication (machine type communication, MTC) terminal, a handheld device having a wireless communication function, a compute device or another processing device connected to a wireless modem, a vehicle-mounted device, a wearable device (also referred to as a wearable smart device), a virtual reality (virtual reality, VR) terminal, an augmented reality (augmented reality, AR) terminal, a wireless terminal in remote medical (remote medical), a wireless terminal in industrial control (industrial control), a wireless terminal in self-driving (self-driving), a wireless terminal in a smart grid (smart grid), a wireless terminal in transportation safety (transportation safety), a wireless terminal in a smart city (smart city), a wireless terminal in a smart home (smart home), or the like. The terminal device may alternatively be a terminal in a 5G system, or a terminal in a next-generation communication system. This is not limited in embodiments of this application.

A device form of the terminal device is not limited in embodiments of this application. An apparatus for implementing a function of the terminal device may be a terminal device, or may be an apparatus, for example, a chip system, that can enable the terminal device to implement the function. The apparatus can be installed in a terminal device or used in cooperation with the terminal device. In embodiments of this application, the chip system may include a chip, or may include a chip and another discrete component.

### 2. Network device

The network device is an entity a network side for signal reception, signal transmission, or signal transmission and reception. The network device may be an apparatus deployed in a radio access network (radio access network, RAN) to provide wireless communication functions for the terminal device.

In a possible scenario, the network device may be a device having a base station function, for example, an evolved NodeB (evolved NodeB, eNodeB), a transmitting and receiving point (transmitting and receiving point, TRP), a transmitting point (transmitting point, TP), a next generation NodeB (next generation NodeB, gNB), a next generation base station in a 6G mobile communication system, an integrated access and backhaul (integrated access and backhaul, IAB) node, or a non-terrestrial network device in an NTN, that is, a device, a satellite, or the like that may be deployed on a high-altitude platform. The network device may be a transmission reception point (transmission reception point, TRP), a base station, or a control node in various forms, for example, a network controller or a wireless controller. Specifically, the network device may be a macro base station in various forms, a micro base station (also referred to as a small cell) in a heterogeneous network (heterogeneous network, HetNet) scenario, a relay station, an access point (access point, AP), a radio network controller (radio network controller, RNC), a NodeB (NodeB, NB), a base station controller (base station controller, BSC), a base transceiver station (base transceiver station, BTS), a home NodeB (for example, a home evolved NodeB or a home NodeB, HNB), a baseband unit (baseband unit, BBU) and a radio frequency unit (remote radio unit, RRU) in a distributed base station scenario, a transmitting and receiving point (transmitting and receiving point, TRP), a transmitting point (transmitting point, TP), a mobile switching center, or the like; or may be an antenna panel of a base station. The control node may be connected to a plurality of base stations, and configure resources for a plurality of terminals covered by the plurality of base stations. In systems using different radio access technologies, names of devices having a base station function may be different. For example, the device may be a gNB in 5G, a network side device in a network after 5G, a network device in a future evolved public land mobile (communication) network (public land mobile network, PLMN), or a device that has a function of a base station in device-to-device (device-to-device, D2D) communication, machine-to-machine (machine-to-machine, M2M) communication, or internet of vehicles communication. A specific name of the network device is not limited in this application. The network device may alternatively be a baseband unit pool (BBU pool), an RRU, or the like in an open access network (open RAN, O-RAN or ORAN) or a cloud radio access network (cloud radio access network, CRAN).

All or some functions of the network device in this application may alternatively be implemented by a software function running on hardware, or may be implemented by a virtualization function instantiated on a platform (for example, a cloud platform). The network device in this application may alternatively be a logical node, a logical module, or software that can implement all or some functions of the network device.

In another possible scenario, a plurality of network devices collaborate to assist the terminal device in implementing wireless access, and different network devices separately implement some functions of the base station. For example, the network device may include a central unit (central unit, CU), a distributed unit (distributed unit, DU), a CU-control plane (control plane, CP), a CU-user plane (user plane, UP), a radio unit (radio unit, RU), or the like. The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH). It may be understood that the network device may be a CU node, a DU node, or a device including the CU node and the DU node. In addition, the CU may be classified as a network device in an access network RAN, or the CU may be classified as a network device in a core network CN. This is not limited herein.

In different systems, the CU (or the CU-CP and the CU-UP), the DU, or the RU may also have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by a software module, a hardware module, or a combination of the software module and the hardware module.

A form of the network device is not limited in embodiments of this application. An apparatus for implementing a function of the network device may be a network device, or may be an apparatus, for example, a chip system, that can enable the network device to implement the function. The apparatus can be installed in a network device or used in cooperation with the network device.

To facilitate understanding of content of the solutions, the following further explains and describes some terms in embodiments of this application, so as to facilitate understanding by a person skilled in the art. This part is merely for ease of understanding, and cannot be considered as a specific limitation on this application.

### 1. Communication process between communication devices

For example, in FIG. 2, a first device may sequentially perform source encoding, channel encoding, rate matching, and modulation on a bit stream generated by a source, and then transmit information to a second device through a channel. Correspondingly, after receiving the information, the second device sequentially performs demodulation, rate de-matching, channel decoding, and source decoding on the information to obtain a sink, that is, restore the bit stream generated by the source. The channel may be an additive white Gaussian noise (additive white Gaussian noise, AWGN) channel. At least one of the first device and the second device may be the terminal device or the network device in FIG. 1.

### 2. Polar (Polar) code

The polar code is a known channel encoding scheme that can be strictly proved to "achieve" a channel capacity, and is characterized by high performance, low complexity, and the like. Currently, the polar code has been determined by the 3GPP as a control channel encoding scheme in 5G control channel enhanced mobile broadband (enhanced mobile broadband, eMBB) scenarios (uplink/downlink).

The polar code is a linear block code whose encoding process may be x_{N}=u_{N}G_{N}, where u_{N}={u₀, u₁, ..., u_{N-1}} is a binary row vector whose length is N, *G_{N}* = F⊗n is an encoding matrix. $F = \left[\begin{matrix}1 & 0 \\ 1 & 1\end{matrix}\right]$, and F⊗n represents a Kronecker power (Kronecker power), which may be defined as F⊗n = F⊗F⊗(n - 1) . For example, if n=2, a polar code encoding matrix $G = F ⊗ n = \left[\begin{matrix}1 & 0 & 0 & 0 \\ 1 & 1 & 0 & 0 \\ 1 & 0 & 1 & 0 \\ 1 & 1 & 1 & 1\end{matrix}\right]$ whose code length N is equal to 4 may be obtained.

In the encoding process of the polar code, u_{N} may be divided into two parts. Some bits carry information and are referred to as information bits. A set of indexes of the information bits may be denoted as A. The remaining bits are fixed values and are referred to as fixed bits, which are usually set to 0. When the fixed bits are set to 0, the encoding process of the polar code may be simplified as x_{A}=u_{A}GN(A), where u_{A} is a set of information bits in u_{N}, and a length of u_{A} may be denoted as K; GN(A) is a submatrix formed by rows corresponding to the indexes in the set A in GN, and GN(A) is a K×N matrix. Selection of the set A affects performance of the polar code.

FIG. 3 is a diagram of polar code encoding. As shown in FIG. 3, u₈={u₀, u₀, ..., u₇} is a binary row vector whose length is 8. The binary row vector may include fixed bits and information bits. The fixed bits and the information bits may be adjacent or interleaved. For example, u₀, u₁, u₂, and u₄ are fixed bits, which may all be 0, and u₃, u₅, u₆, and u₇ are information bits. A circled plus symbol shown in FIG. 3 represents an exclusive OR operation, u₀, u₁, u₂, and u₄ are four bits having lowest reliability, and u₃, u₅, u₆, and u₇ are four bits having highest reliability. An intermediate result in the encoding process shown in FIG. 3 is merely an example. This is not limited in embodiments of this application. In this application, polar code encoding and polar outer code encoding may be used interchangeably.

In this application, the polar code may include at least one of the following: an Arikan polar (Arikan Polar) code, a parity-check polar (PC-Polar) code, a cyclic redundancy check-aided polar (CA-Polar) code, a parity-check cyclic redundancy check-aided polar (PC-CA-Polar) code, or the like. The Arikan polar code is an original polar code that is not concatenated with another code, and includes an information bit and/or a frozen bit. The PC-polar code is a polar code that is concatenated with a PC code. The CA-polar code is a polar code that is concatenated with a CRC code. The PC-CA-polar code is a polar code that is concatenated with both a PC code and a CRC code.

The CRC code, as a commonly used error detection code, is one of the most common outer codes concatenated with a polar code. In this application, a length of the CRC code may be R bits, and R may be a positive integer, for example, 4, 6, 8, 11, 16, or 24. The length of the CRC code is not limited in this application. It should be understood that the CRC code may be obtained based on a generator polynomial, and a generator polynomial of an R-bit CRC code may have a degree of R. CRC codes of different lengths use different polynomials. For example, a length of the CRC code is 24 bits, and a polynomial used by the CRC code may be CRC24. A specific polynomial used by the CRC code is not limited in this application.

There are a plurality of possible implementations of polar code decoding, for example, successive cancellation decoding (successive cancellation decoding, SC), successive cancellation list decoding (successive cancellation list decoding, SCL), successive cancellation stack (successive cancellation stack, SCS) decoding, cyclic redundancy check-aided successive cancellation list (CRC-aided successive cancellation list, CA-SCL) decoding, belief propagation (belief propagation, BP) decoding, and soft cancellation (soft cancellation, SCAN) decoding. A manner of polar code decoding is not limited in this application. For example, when the polar code is an Arikan polar code, SC decoding, SCL decoding, SCS decoding, BP decoding, or SCAN decoding may be used; and when the polar code is a PC-polar code, a CA-polar code, or a PC-CA-polar code, CA-SCL decoding may be used.

### 3. LDPC code

LDPC codes are a type of linear block codes with a sparse check matrix. To be specific, density of non-zero entries in the check matrix (which may also be referred to as a parity check matrix or an LDPC matrix) is low, meaning that a quantity of zero entries in the check matrix needs to be far greater than that of non-zero entries. An LDPC code may be represented by a check matrix or a Tanner graph. A specific representation form of the LDPC code is not limited in this application. For ease of understanding, the following uses an example in which the LDPC code is represented by a check matrix for description, which should not be considered as any limitation on this application.

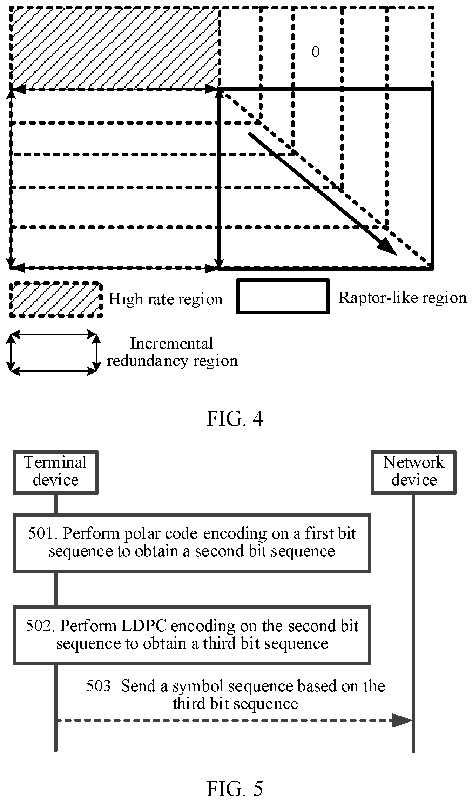

For the check matrix of the LDPC code, refer to FIG. 4. In FIG. 4, the check matrix includes a high rate region (high rate region), an incremental redundancy region (incremental redundancy region), and a raptor-like region (raptor-like region). A region selected with dashed lines indicates a code rate. A main feature of the check matrix is nesting, meaning that a low rate region may include a high rate region, and the high rate region may be used as a submatrix of the low rate region. In a possible implementation, different matrix regions may be selected as the check matrix based on the code rate, for example, regions from the top left region to the bottom right region of the matrix, such as a row 0 to a row M₀ and a column 0 to a column N₀. M₀ and N₀ may be integers greater than 0.

Optionally, the check matrix of the LDPC code may be obtained based on a base graph (base graph, BG) and a shifting value (shifting value). The base graph may be determined based on a length and a code rate of information bits. The code rate is a ratio of bits before encoding (that is, information bits) to bits after encoding. Base graphs may be classified into BG1 and BG2. For example, BG1 is applicable to information bits with a code length of 308 bits to 8448 bits and a code rate of 0.25 to 0.95. BG2 is applicable to information bits with a code length of 40 bits to 3840 bits and a code rate of 0.20 to 0.95.

It should be noted that, in this application, a row number and a column number of the base graph may be numbered from 0, and a row number and a column number of the matrix may be numbered from 0. A specific value from which the row number and the column number are numbered is not limited in this application.

Generally, the base graph may include m×n matrix entries (entry), and may be represented by a matrix with m rows and n columns. A value of the matrix entry may be 0 or 1. An entry whose value is 0 may be referred to as a zero entry, indicating that the entry may be replaced by a Z×Z zero matrix (zero matrix). An entry whose value is 1 may be referred to as a non-zero entry, indicating that the entry may be replaced by a Z×Z circulant permutation matrix (circulant permutation matrix). In other words, each matrix entry indicates one zero matrix or one circulant permutation matrix.

Z may be a positive integer, and may be referred to as a lifting (lifting) factor, which may also be referred to as a lifting size, a lifting factor, or the like, and may be, for example, determined based on a length of information bits. For example, Z may be *aⱼ* × 2*^{kⱼ},* where *aⱼ* ∈ {2, 3, 5, 7, 9,11,13, 15}, max (*kⱼ*) ∈ {7, 7, 6, 5, 5, 5, 4, 4}, and j is an integer greater than or equal to 0. For example, Z may be 2 × 2*^{kⱼ},* and *kⱼ* E {0, 1, 2, 3, 4, 5, 6, 7}. For example, Z may be 3 × 2*^{kⱼ}* , and *kⱼ* ∈ {0,1, 2, 3, 4, 5, 6, 7} . For example, Z may be 5 × 2*^{kⱼ} ,* and *kⱼ* ∈ {0,1, 2, 3, 4, 5, 6}. For example, Z may be 7 × 2*^{kj},* and *kⱼ* ∈ { 0, 1, 2, 3, 4, 5}. For example, Z may be 9 × 2*^{kⱼ},* and *kⱼ* ∈ {0, 1, 2, 3, 4, 5}. Others are similar, and are not listed one by one herein.

Optionally, there is an association relationship between Z and a shifting value. For example, a set including a plurality of Zs (which may be referred to as a set of lifting factors (set of lifting sizes), where the set of lifting factors is used as an example for description below) may correspond to a shifting value. For example, a row number of the set of lifting factors corresponds to a column number of the shifting value. Optionally, the column number of the shifting value may be described as a set index (set index). Specifically, in Table 1, the set of lifting factors may correspond to the set index. For example, {2, 4, 8, 16, 32, 64, 128, 256} corresponds to 0. Others are similar, and are not described herein again.

**Table 1 Set of LDPC lifting sizes (set of LDPC lifting sizes Z)**

| Set index (set index) (*i_{LS}*) | Set of LDPC lifting sizes (set of lifting sizes) (Z) |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

With reference to a specific example, the following describes a process in which entries in the base graph are replaced by a Z×Z matrix. Specifically, it is assumed that an entry value in a row i and a column j in the base graph is 1, a shifting value of the element value is P_{i, j}, and P_{i,j} is an integer greater than or equal to 0. The entry whose value is 1 in the row i and the column j in the base graph may be replaced with a Z×Z circulant permutation matrix corresponding to P_{i,j}, and the circulant permutation matrix may be obtained by performing P_{i,j} times of right cyclic shift on a Z×Z identity matrix. It may be learned that, in the base graph, each entry whose value is 0 is replaced with the Z×Z zero matrix, and each entry whose value is 1 is replaced with the Z×Z circulant permutation matrix corresponding to the shifting value of the entry, so that a check matrix of the LDPC code can be obtained. The base graph may indicate a position of the shifting value, and the non-zero entry in the base graph corresponds to the shifting value. It may be learned that a parity check matrix H has a size of (m×Z)×(n×Z). For example, it is assumed that Z=4, and each zero entry is replaced by a zero matrix with a size of 4×4. Assuming that P_{2, 3}=2, a non-zero entry in a row 2 and a column 3 is replaced by a 4×4 circulant permutation matrix, and the matrix is obtained by performing two times of right cyclic shift on a 4×4 identity matrix. It should be noted that this is merely an example for description herein, and does not constitute a limitation.

There are a plurality of possible implementations of the LDPC code, for example, minimum sum (Min-Sum, MS) decoding or BP decoding. A manner of LDPC code decoding is not limited in this application. Optionally, the MS decoding may be further divided into offset minimum sum (Offset-MS) decoding and normalized minimum sum (Normalized-MS) decoding. The offset minimum sum decoding may be, for example, layered offset minimum sum (layered offset min-sum, LOMS) decoding.

The following describes in detail embodiments of this application with reference to FIG. 5. It should be noted that the method provided in this application may be performed by the first device and the second device in FIG. 2. The following uses an example in which the first device is a terminal device and the second device is a network device for description, which should not be considered as any limitation on this application. Processing performed by a single execution entity (the terminal device or the network device) shown in embodiments of this application may alternatively be performed by a plurality of execution entities. These execution entities may be logically and/or physically separated. For example, processing performed by the network device may be performed by at least one of a CU, a DU, and an RU. In addition, embodiments of this application are described only by using an example in which all steps included in the embodiments are performed, which should not be considered as any limitation on this application. In other words, the steps included in embodiments of this application (any one of the embodiments in FIG. 5 to FIG. 8) may be partially or completely performed when there is no logical conflict.

FIG. 5 shows an encoding method according to an embodiment of this application. The encoding method includes but is not limited to the following steps.

501. The terminal device performs polar code encoding on a first bit sequence to obtain a second bit sequence.

The first bit sequence may include at least one of the following: an information bit sequence, a frozen bit sequence, or a check bit sequence. The information bit sequence is a sequence including information bits, and the frozen bit sequence is a sequence including frozen bits. The check bit sequence may include a PC code and/or a CRC code. The following describes the first bit sequence in two cases, which should not be considered as any limitation on this application. Details are as follows:
In a first case, the first bit sequence includes the information bit sequence.

In a second case, the first bit sequence includes the information bit sequence and the check bit sequence.

The second bit sequence may be a polar code. For example, for the first case, the second bit sequence may be an Arikan polar code. For the second case, the second bit sequence may be a PC-polar code, a CA-polar code, or a PC-CA-polar code.

In a possible implementation, a length Npolar of the second bit sequence may be determined based on a length T of the first bit sequence and a code rate R corresponding to the second bit sequence. For example, the length of the second bit sequence meets the following condition: $Npolar = \left⌈\frac{T}{R}\right⌉$.

In this application, 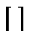 is rounding up. Herein, rounding up is merely used as an example, which should not be considered as any limitation on this application. For example, rounding up in this application may be replaced with rounding down.

R may be the code rate corresponding to the second bit sequence. R may be a predefined or preconfigured value greater than 0, or R may be indicated by the network device to the terminal device. For example, R may be 0.9517, or R may be (Nm×0.9517)/Nm, for example, 975/1024. Nm is a maximum length supported by polar code encoding. Optionally, Nm may be an integer greater than 0, for example, Nm is 1024.

In a possible implementation, the information bit sequence in the first bit sequence may be a part or all of an initial bit sequence. The initial bit sequence in this application may be referred to as a mother code. The initial bit sequence may include an information bit sequence. Optionally, the initial bit sequence may or may not include a frozen bit sequence. The following describes a relationship between the first bit sequence and the initial bit sequence by using an example in which the initial bit sequence does not include the frozen bit sequence, which should not be considered as any limitation on this application. Details are as follows:
1. The information bit sequence in the first bit sequence is the information bit sequence in the initial bit sequence. For example, when a length of the initial bit sequence is less than a maximum length Kcb supported by LDPC encoding, the information bit sequence in the first bit sequence is the information bit sequence in the initial bit sequence. In other words, the information bit sequence in the first bit sequence is all of the initial bit sequence, that is, the first bit sequence that is not concatenated with the check bit sequence is the same as the initial bit sequence.

Kcb may be determined based on a base graph. For example, if the base graph is BG1, Kcb is 8448. If the base graph is BG2, Kcb is 3840. The base graph is determined based on a length and a code rate of the information bits in the initial bit sequence.

2. The terminal device may segment the initial bit sequence based on a first segment length to obtain L bit sequences, where L is an integer greater than 1. For example, when the length of the initial bit sequence is greater than Kcb, the terminal device may segment the initial bit sequence based on the first segment length to obtain the L bit sequences. In other words, the information bit sequence in the first bit sequence is a part of the initial bit sequence, that is, the first bit sequence that is not concatenated with the check bit sequence is the part of the initial bit sequence.

The L bit sequences may include a fourth bit sequence. For example, for the first case, the fourth bit sequence may be used as the first bit sequence. For the second case, the terminal device may perform check coding on the fourth bit sequence to obtain the first bit sequence. The check coding may be PC encoding and/or CRC encoding. For example, CRC encoding is performed on the fourth bit sequence. The terminal device may concatenate a 24-bit CRC code at the end of the fourth bit sequence to obtain the first bit sequence.

It should be noted that, that the length of the initial bit sequence is equal to Kcb may be used as a condition in which "the information bit sequence in the first bit sequence is the information bit sequence in the initial bit sequence", or used as a condition in which "the terminal device segments the initial bit sequence based on the first segment length to obtain the L bit sequences". This is not limited herein.

In a possible implementation, the first segment length may be determined based on a first value R and Kcb. For example, the first segment length meets the following condition: K1 = $\left⌈R\times Kcb\right⌉$. For example, assuming that R is 0.9517, and Kcb is 3840, K1 may be $\left⌈0.9517\times 3840\right⌉ = 3655$.

In a possible implementation, lengths of the L bit sequences may be partially the same, completely the same, or completely different. It should be understood that processes of encoding the L bit sequences are similar. For example, for this, refer to FIG. 5. Details are not described herein again.

In a possible implementation, a length of the information bit sequence in the first bit sequence may be greater than, equal to, or less than Nm. For example, when the length of the information bit sequence in the first bit sequence is greater than or equal to Nm, the terminal device may further segment the first bit sequence based on a second segment length to obtain P bit sequences, where P is an integer greater than 1. In this case, step 501 may include: The terminal device separately performs polar code encoding on the P bit sequences, to concatenate the P bit sequences into the second bit sequence. A process of concatenating the bit sequences on which polar code encoding is performed is not limited in this application.

Optionally, the second segment length may be determined based on Nm and R, for example, meets the following condition: $K 2 = \left⌈Nm\times R\right⌉$. For example, assuming that R is 0.9517, and Nm is 1024, K2 may be $\left⌈0.9517\times 1024\right⌉ = 975$.

In a possible implementation, lengths of the P bit sequences may be partially the same, completely the same, or completely different. For example, the first bit sequence includes 2924 bits, and the second segment length is 975. The terminal device may segment the first bit sequence into three bit sequences with lengths of 975, 975, and 974 based on the second segment length. That is, the lengths of two of the three bit sequences are the same.

502. The terminal device performs LDPC encoding on the second bit sequence to obtain a third bit sequence.

The third bit sequence is an LDPC code, and may also be referred to as an LDPC codeword sequence.

Optionally, after step 502, step 503 may be further included.

503. The terminal device sends a symbol sequence based on the third bit sequence.

Correspondingly, the network device receives the symbol sequence. For example, the network device receives the symbol sequence from the terminal device. Correspondingly, the terminal device sends the symbol sequence to the network device based on the third bit sequence.

Optionally, step 503 may include: The terminal device modulates the third bit sequence based on a modulation scheme to obtain the symbol sequence. The modulation scheme in this application may be quadrature phase shift keying (quadrature phase shift keying, QPSK), binary phase shift keying (binary phase shift keying, BPSK), 16-quadrature amplitude modulation (quadrature amplitude modulation, QAM), 64-QAM, 256-QAM, 1024-QAM, 4096-QAM, or the like. This is not limited in this application.

It can be learned that, in the foregoing embodiment, the terminal device may first perform polar code encoding on the first bit sequence to obtain the second bit sequence, and then perform LDPC encoding on the second bit sequence to obtain the third bit sequence, that is, the LDPC code. This reduces an error floor in LDPC decoding without sacrificing a code rate of an LDPC code, thereby improving error correction performance of the LDPC code.

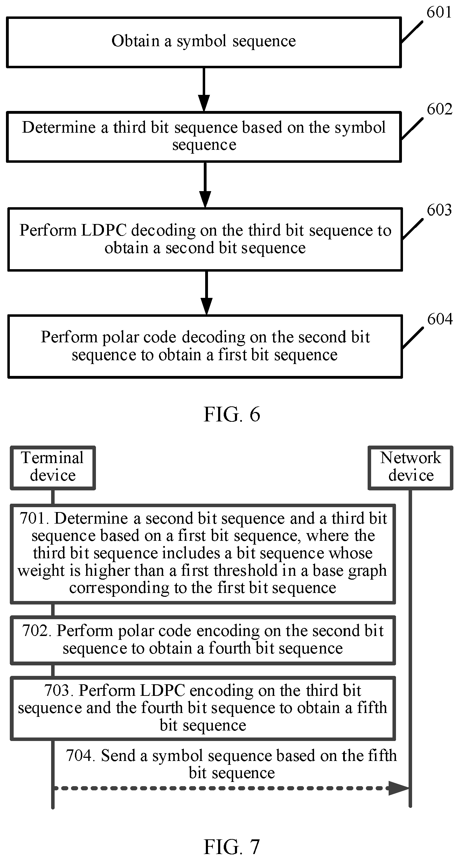

FIG. 6 shows a decoding method according to an embodiment of this application. It should be noted that, the embodiment shown in FIG. 5 or the embodiment shown in FIG. 6 may be separately performed, or the embodiment shown in FIG. 5 and the embodiment shown in FIG. 6 may be combined. For example, the embodiment shown in FIG. 5 is performed before step 601 in FIG. 6. The following describes the embodiment shown in FIG. 6 in detail. Specifically, the method includes but is not limited to the following steps.

601. The network device obtains the symbol sequence.

For example, the network device receives the symbol sequence from the terminal device.

602. The network device determines the third bit sequence based on the symbol sequence.

Optionally, the network device may demodulate the symbol sequence based on the modulation scheme to obtain the third bit sequence. The third bit sequence is the LDPC code, and may also be referred to as the LDPC codeword sequence.

603. The network device performs LDPC decoding on the third bit sequence to obtain the second bit sequence.

For a manner in which the network device performs LDPC decoding on the third bit sequence, refer to the foregoing related descriptions. Details are not described herein again. The second bit sequence is similar to the second bit sequence in step 501 in FIG. 5. Details are not described herein again.

604. The network device performs polar code decoding on the second bit sequence to obtain the first bit sequence.

The first bit sequence is similar to the first bit sequence in step 501 in FIG. 5. Details are not described herein again. For a manner in which the network device performs polar code decoding on the second bit sequence, refer to the foregoing related descriptions. Details are not described herein again.

It can be learned that, in the foregoing embodiment, the network device may first determine the third bit sequence based on the symbol sequence, to perform LDPC decoding on the third bit sequence to obtain the second bit sequence, and then perform polar code decoding on the second bit sequence to obtain the first bit sequence. This can reduce an error floor in LDPC decoding, thereby improving error correction performance of an LDPC code.

FIG. 7 shows another encoding method according to this application. The method includes but is not limited to the following steps.

701. A terminal device determines a second bit sequence and a third bit sequence based on a first bit sequence, where the third bit sequence includes a bit sequence whose weight is higher than a first threshold in a base graph corresponding to the first bit sequence.

The first bit sequence may include at least one of the following: an information bit sequence, a frozen bit sequence, or a check bit sequence. The information bit sequence is a sequence including information bits, and the frozen bit sequence is a sequence including frozen bits. The check bit sequence may include a PC code and/or a CRC code. The following describes the first bit sequence in two cases, which should not be considered as any limitation on this application. Details are as follows:

In a first case, the first bit sequence includes the information bit sequence.

In a second case, the first bit sequence includes the information bit sequence and the check bit sequence. In this case, the terminal device may perform check coding on a seventh bit sequence to obtain the first bit sequence. The check coding may be PC encoding and/or CRC encoding. For example, CRC encoding is performed on the seventh bit sequence. The terminal device may concatenate a 24-bit CRC code at the end of the seventh bit sequence to obtain the first bit sequence.

Optionally, step 701 may include: The terminal device determines a first value based on a first quantity of columns whose weights are greater than the first threshold in the base graph, so that the terminal device can determine the third bit sequence from the first bit sequence based on the first value and a lifting factor corresponding to the first bit sequence, and can determine the second bit sequence based on the third bit sequence and the first bit sequence.

There may be the following several implementations in which the terminal device determines the first value based on the first quantity of columns whose weights are higher than the first threshold in the base graph. Details are as follows:
1. The first value is the first quantity of columns. The first quantity of columns is an integer greater than or equal to 1. For example, the first quantity of columns may be 2 or 3. Generally, weights of first T columns in the base graph are higher than the first threshold, and T is the first quantity of columns. For example, it is assumed that the first quantity of columns is 2, that is, weights of a column 0 and a column 1 in the base graph are higher than the first threshold. Alternatively, it is assumed that the first quantity of columns is 3, that is, weights of a column 0 to a column 2 in the base graph are higher than the first threshold. The first threshold may be a predefined or preconfigured value greater than 0.
2. The terminal device determines a second quantity of columns having highest reliability (that is, a lowest bit error rate) from columns other than the columns whose weights are higher than the first threshold in the base graph, and determines the first value based on the first quantity of columns and the second quantity of columns. For example, the terminal device sorts reliability of the other columns in descending or ascending order of reliability, to collect statistics on a quantity of columns having highest reliability, to obtain the second quantity of columns. The descending order of reliability may be understood as an ascending order of a bit error rate, and vice versa.

In a possible implementation, the first value may be a sum of the first quantity of columns and the second quantity of columns. For example, it is assumed that the base graph includes 10 columns, and the first quantity of columns is 2, that is, weights of a column 0 and a column 1 in the base graph are higher than the first threshold. The terminal device may sort reliability of a column 2 to a column 9 in descending or ascending order of reliability, to collect statistics on a quantity of columns having highest reliability, to obtain the second quantity of columns. For example, the second quantity of columns may be an integer greater than or equal to 1.

3. The terminal device determines a third quantity of columns whose reliability is higher than a second threshold from columns other than the columns whose weight are higher than the first threshold in the base graph, and determines the first value based on the first quantity of columns and the third quantity of columns. For example, the first value is a sum of the first quantity of columns and the third quantity of columns. The third threshold may be a predefined or preconfigured value greater than 0.

A weight in the base graph may be understood as a weight of a column in the base graph. Herein, the column weight is merely used as an example for description, which should not be considered as any limitation on this application. It should be noted that, in this application, the weight in the base graph is determined by a quantity of non-zero entries. For example, a weight of a row is a quantity of non-zero entries included in the row, and a weight of a column is a quantity of non-zero entries included in the column. The weight of the row and the weight of the column may be referred to as a row weight and a column weight respectively for short.

In a possible implementation, the base graph may be determined based on a length and a code rate of information bits in an initial bit sequence. The lifting factor corresponding to the first bit sequence may be determined based on a length of information bits in the initial bit sequence. The information bit sequence in the first bit sequence may be a part or all of the initial bit sequence. The initial bit sequence may include an information bit sequence. Optionally, the initial bit sequence may or may not include a frozen bit sequence. The following describes a relationship between the first bit sequence and the initial bit sequence by using an example in which the initial bit sequence does not include the frozen bit sequence, which should not be considered as any limitation on this application. Details are as follows:
1. The information bit sequence in the first bit sequence is the information bit sequence in the initial bit sequence. For example, when a length of the initial bit sequence is less than a maximum length Kcb supported by LDPC encoding, the information bit sequence in the first bit sequence is the information bit sequence in the initial bit sequence. In other words, the information bit sequence in the first bit sequence is all of the initial bit sequence, that is, the first bit sequence that is not concatenated with the check bit sequence is the same as the initial bit sequence.

Kcb may be determined based on a base graph. For example, if the base graph is BG1, Kcb is 8448. If the base graph is BG2, Kcb is 3840. The base graph is determined based on the length and the code rate of the information bits in the initial bit sequence.

2. The terminal device may segment the initial bit sequence based on a first segment length to obtain X bit sequences, where X is an integer greater than 1. For example, when the length of the initial bit sequence is greater than Kcb, the terminal device may segment the initial bit sequence based on the first segment length to obtain the X bit sequences. The X bit sequences may include the first bit sequence or the seventh bit sequence. For example, for the first case, the X bit sequences include the first bit sequence. In other words, the information bit sequence in the first bit sequence is a part of the initial bit sequence. For the second case, the X bit sequences include the seventh bit sequence. In other words, the seventh bit sequence is a part of the initial bit sequence.

It should be noted that, that the length of the initial bit sequence is equal to Kcb may be used as a condition in which "the information bit sequence in the first bit sequence is the information bit sequence in the initial bit sequence", or used as a condition in which "the terminal device segments the initial bit sequence based on the first segment length to obtain the X bit sequences". This is not limited herein.

Optionally, the first segment length may be determined based on the first value and the lifting factor. For example, the first segment length may be determined based on the first value, the lifting factor, and a second value. The second value is determined based on a total quantity of columns in the base graph and the first value. For example, the second value is a difference between the total quantity of columns in the base graph and the first value.

Optionally, the first segment length may alternatively be determined based on a third value. The third value is a code rate corresponding to the second bit sequence. The third value may be a predefined or preconfigured value greater than 0, or the third value may be indicated by the network device to the terminal device. For example, the third value may be 0.9517, or the third value may be (Nm×0.9517)/Nm, for example, 975/1024. Nm is a maximum length supported by polar code encoding. Nm may be an integer greater than 0, for example, Nm is 1024.

In a possible implementation, the first segment length may meet the following condition: $K 1 = \left⌈\left(a+b\times R\right)\times Z\right⌉$, where a is the first value, b is the second value, R is the third value, and Z is the lifting factor. For example, assuming that Z is 384, a is 2, b is 8, and R is 0.9517, $K 1 = \left⌈\left(a+b\times R\right)\times Z\right⌉ = a \times Z + \left⌈b\times Z\times R\right⌉ = 2924$. a × Z = M1, and $\left⌈b\times Z\times R\right⌉ = M 2$. Therefore, K1 = M1 + M2.

For example, that the terminal device determines the third bit sequence from the first bit sequence based on the first value and the lifting factor corresponding to the first bit sequence may include: The terminal device selects first Q bits from the first bit sequence as the third bit sequence based on a product Q of the first value and the lifting factor. For example, if the first value is 2, and the lifting factor is 104, Q may be 208.

There may be the following several implementations in which the terminal device determines the second bit sequence based on the third bit sequence and the first bit sequence. Details are as follows:

1. The second bit sequence is another bit sequence other than the third bit sequence in the first bit sequence. For example, when a length of the another bit sequence is less than Nm, the second bit sequence is the another bit sequence.

2. The terminal device segments the another bit sequence based on a second segment length to obtain Y bit sequences, where the Y bit sequences include the second bit sequence. For example, when the length of the another bit sequence is greater than Nm, the terminal device segments the another bit sequence based on the second segment length to obtain the Y bit sequences. Y is an integer greater than 1. The second segment length may be determined based on Nm and the third value. For example, the second segment length meets the following condition: $K 2 = \left⌈Nm\times R\right⌉$.

It should be noted that, that the length of the another bit sequence is equal to Nm may be used as a condition in which "the second bit sequence is the another bit sequence", or used as a condition in which "the terminal device segments the another bit sequence based on the second segment length to obtain the Y bit sequences". This is not limited herein.

702. The terminal device performs polar code encoding on the second bit sequence to obtain a fourth bit sequence.

For example, for the first case, step 702 may be understood as: The terminal device performs check coding on the second bit sequence to obtain a sixth bit sequence, and performs polar code encoding on the sixth bit sequence to obtain the fourth bit sequence. The fourth bit sequence may be a polar code, for example, a PC-polar code, a CA-polar code, or a PC-CA-polar code.

In a possible implementation, a length Npolar of the fourth bit sequence may be determined based on a length T and R of the second bit sequence. For example, the length of the fourth bit sequence meets the following condition: $Npolar = \left⌈\frac{T}{R}\right⌉$.

703. The terminal device performs LDPC encoding on the third bit sequence and the fourth bit sequence to obtain a fifth bit sequence.

The fifth bit sequence is an LDPC code, and may also be referred to as an LDPC codeword sequence. In a possible implementation, step 703 may include: The terminal device performs LDPC encoding on a bit sequence obtained by concatenating the third bit sequence and the fourth bit sequence, to obtain the fifth bit sequence. For example, the fourth bit sequence is concatenated at the end of the third bit sequence.

Optionally, after step 703, step 704 may be further included.

704. The terminal device sends a symbol sequence based on the fifth bit sequence.

Correspondingly, the network device receives the symbol sequence. For example, the network device receives the symbol sequence from the terminal device. Correspondingly, the terminal device sends the symbol sequence to the network device based on the fifth bit sequence.

Optionally, step 704 may include: The terminal device modulates the fifth bit sequence based on a modulation scheme to obtain the symbol sequence.

It can be learned that, in the foregoing embodiment, the terminal device may determine the second bit sequence and the third bit sequence based on the first bit sequence, where the third bit sequence includes the bit sequence whose weight is higher than the first threshold in the base graph corresponding to the first bit sequence. In other words, a weight corresponding to the second bit sequence is lower than a weight corresponding to the third bit sequence. Further, the terminal device may perform polar code encoding on the second bit sequence, to provide additional protection for the second bit sequence having a lower weight in a polar code encoding manner, so as to improve error correction performance. LDPC encoding may be performed on the third bit sequence having a higher weight together with a polar code encoding result (that is, the fourth bit sequence obtained by performing polar code encoding on the second bit sequence). In this way, an error floor in LDPC decoding can be reduced, and error correction performance of an LDPC code can be improved. In addition, LDPC encoding payload caused by polar outer code encoding can be further reduced, to reduce a code rate of the LDPC code and improve waterfall region performance.

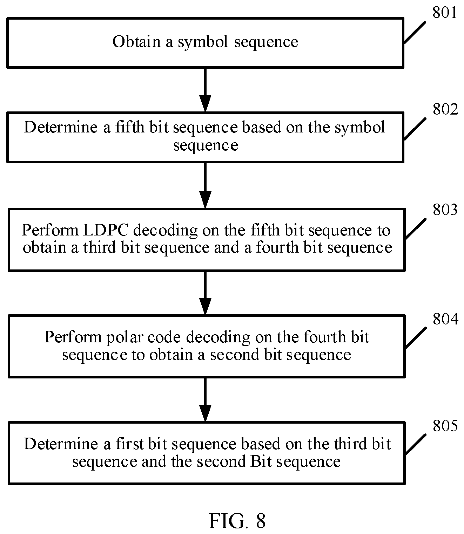

FIG. 8 shows another decoding method according to an embodiment of this application. It should be noted that, the embodiment shown in FIG. 7 or the embodiment shown in FIG. 8 may be separately performed, or the embodiment shown in FIG. 7 and the embodiment shown in FIG. 8 may be combined. For example, the embodiment shown in FIG. 7 is performed before step 801 in FIG. 8. The following describes the embodiment shown in FIG. 8 in detail. Specifically, the method includes but is not limited to the following steps.

801. The network device obtains the symbol sequence.

For example, the network device receives the symbol sequence from the terminal device.

802. The network device determines the fifth bit sequence based on the symbol sequence.

Optionally, the network device may demodulate the symbol sequence based on the modulation scheme to obtain the fifth bit sequence. The fifth bit sequence is the LDPC code, and may also be referred to as the LDPC codeword sequence.

803. The network device performs LDPC decoding on the fifth bit sequence to obtain the third bit sequence and the fourth bit sequence.

For example, the network device performs LDPC decoding on the fifth bit sequence, to obtain the bit sequence obtained by concatenating the third bit sequence and the fourth bit sequence. For a manner in which the network device performs LDPC decoding on the fifth bit sequence, refer to the foregoing related descriptions. Details are not described herein again. The third bit sequence and the fourth bit sequence are respectively similar to the third bit sequence and the fourth bit sequence in step 701 in FIG. 7. Details are not described herein again. The length of the fourth bit sequence meets the following condition: $Npolar = \left⌈\frac{T}{R}\right⌉$. For example, last Npolar bits in "the bit sequence obtained by concatenating the third bit sequence and the fourth bit sequence " may be used as the fourth bit sequence, and remaining bits may be used as the third bit sequence. In other words, a difference between a length of the bit sequence obtained by concatenating the third bit sequence and the fourth bit sequence and Npolar is a length of the third bit sequence.

804. The network device performs polar code decoding on the fourth bit sequence to obtain the second bit sequence.

The second bit sequence is similar to the second bit sequence in step 701 in FIG. 7. Details are not described herein again. For a manner in which the network device performs polar code decoding on the fourth bit sequence, refer to the foregoing related descriptions. Details are not described herein again.

805. The network device determines the first bit sequence based on the third bit sequence and the second bit sequence.

For example, the first bit sequence includes the third bit sequence and the second bit sequence. For example, a bit sequence in which the second bit sequence is concatenated at the end of the third bit sequence is the first bit sequence. The first bit sequence is similar to the first bit sequence in step 701 in FIG. 7. Details are not described herein again. Optionally, when the first bit sequence includes the check bit sequence, the network device may further check the first bit sequence, for example, PC check and/or CRC check.

It can be learned that, in the foregoing embodiment, the network device may first determine the fifth bit sequence based on the symbol sequence, and then perform LDPC decoding on the fifth bit sequence to obtain the third bit sequence and the fourth bit sequence, so that polar code decoding can be performed on the fourth bit sequence to obtain the second bit sequence. In this way, the first bit sequence may be determined based on the third bit sequence and the second bit sequence. Because the network device performs polar code decoding on a part of bit sequences (for example, the fourth bit sequence) in an LDPC decoding result, a decoding delay is reduced and decoding efficiency is improved. In addition, this can further reduce an error floor in LDPC decoding, thereby improving error correction performance of an LDPC code.

The following describes in detail beneficial effects of the embodiments in FIG. 5 to FIG. 8 with reference to specific examples. Details are as follows:

### 1. Examples of the encoding method shown in FIG. 5 and the decoding method shown in FIG. 6

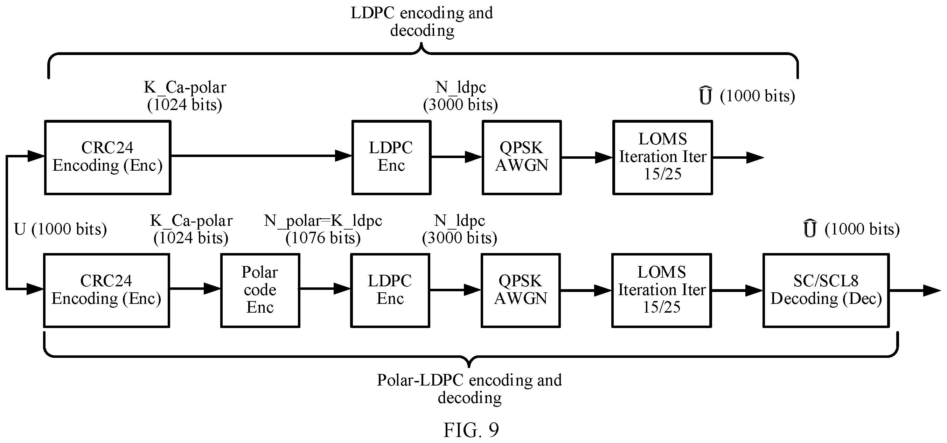

It is assumed that a length of information bits U is 1000 bits (bits). With reference to the encoding method shown in FIG. 5 and the decoding method shown in FIG. 6, for a process of the encoding method and the decoding method, refer to a Polar-LDPC encoding and decoding process in FIG. 9. For example, after sequentially performing CRC24 encoding, polar code encoding, LDPC encoding, and QPSK modulation on the information bits, the terminal device sends information to the network device through an AWGN channel. Correspondingly, after receiving the information, the network device sequentially performs demodulation, LOMS decoding, and polar code decoding on the information to obtain Û. CRC24 encoding and polar code encoding are sequentially performed on the information bits U, to add a polar redundancy check bit to a CRC codeword. After CRC24 encoding is performed on the information bits, a length of the bit sequence is 1024 bits, that is, K_Ca-polar=1024 bits in FIG. 9. After polar code encoding is performed on the 1024 bits, a length N_polar of the bit sequence is $\left⌈\frac{1024}{0.9517}\right⌉ = 1076$ bits. N_polar=K_ldpc. Further, after LDPC encoding is performed on the 1076 bits, a length of the bit sequence is N_ldpc, for example, 3000 bits.

An LDPC encoding and decoding process in FIG. 9 is as follows: After sequentially performing CRC24 encoding, LDPC encoding, and QPSK modulation on the information bits, the terminal device sends the information to the network device through the AWGN channel. Correspondingly, after receiving the information, the network device sequentially performs demodulation and LOMS decoding on the information to obtain Û . In addition, in FIG. 9, iterations of LOMS decoding may be 15 or 25, polar code decoding may be SC decoding or SCL decoding, and a path width L may be 8. A length of Û is 1000 bits.

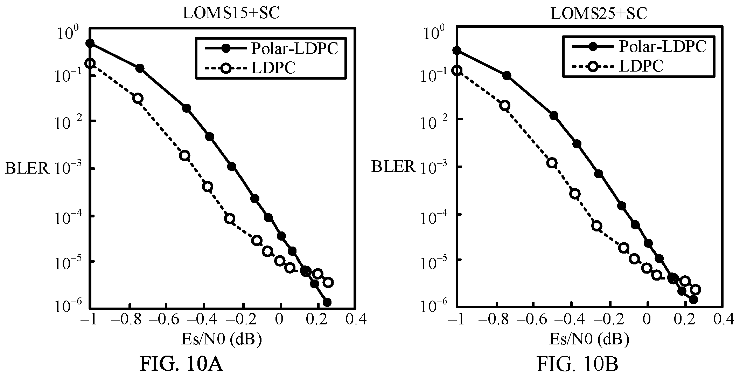

The following describes, based on the example shown in FIG. 9, beneficial effects of the encoding method shown in FIG. 5 and the decoding method shown in FIG. 6 with reference to FIG. 10A and FIG. 10B. Specifically, in FIG. 10A and FIG. 10B, horizontal coordinates represent SNRs, that is, Es/N0, and vertical coordinates represent BLERs.

In FIG. 10A, iterations of LOMS decoding are 15. A curve of Polar-LDPC represents BLER performance corresponding to the Polar-LDPC encoding and decoding process in FIG. 9. A curve of LDPC represents BLER performance corresponding to the LDPC encoding and decoding process in FIG. 9. It can be learned that, in a case in which the BLER is less than or equal to 6×10⁻⁶, error correction performance corresponding to the Polar-LDPC encoding and decoding may still decrease exponentially as the SNR increases, and there is no error floor.

In FIG. 10B, iterations of LOMS decoding are 25. A curve of Polar-LDPC represents BLER performance corresponding to the Polar-LDPC encoding and decoding process in FIG. 9. A curve of LDPC represents BLER performance corresponding to the LDPC encoding and decoding process in FIG. 9. It can be learned that, in a case in which the BLER is less than or equal to 6×10⁻⁶, error correction performance corresponding to the Polar-LDPC encoding and decoding may still decrease exponentially as the SNR increases, and there is no error floor.

### 2. Examples of the encoding method shown in FIG. 7 and the decoding method shown in FIG. 8

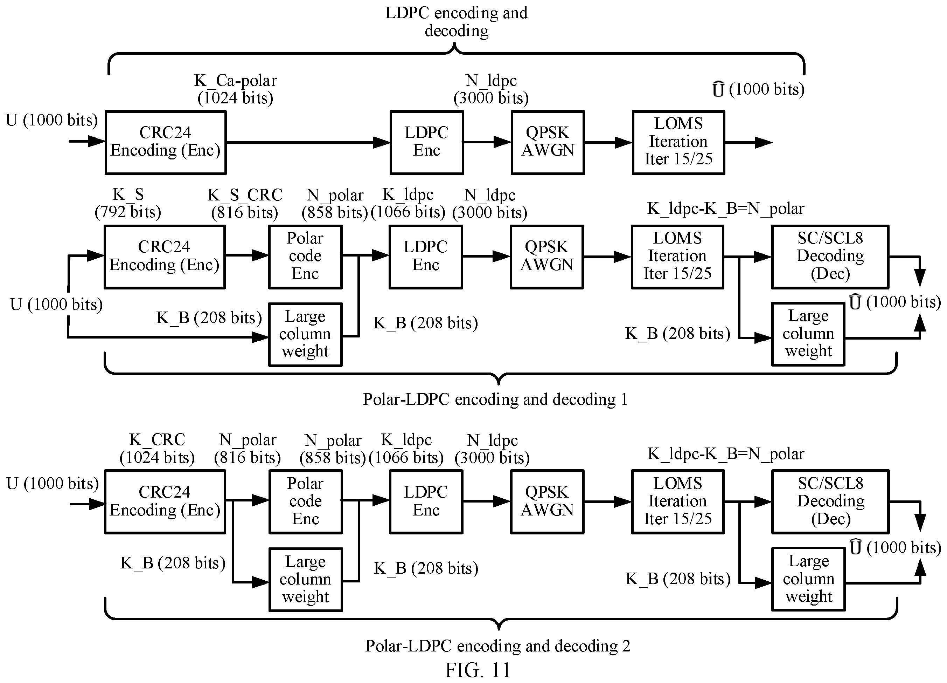

It is assumed that a length of information bits U is 1000 bits (bits). With reference to the encoding method shown in FIG. 7 and the decoding method shown in FIG. 8, for a process of the encoding method and the decoding method, refer to a Polar-LDPC encoding and decoding process 1 or a Polar-LDPC encoding and decoding process 2 in FIG. 11. For example, the terminal device determines a lifting factor Z based on the length of the information bits U. For example, if a length of the information bits is 1000 bits, and a length N_ldpc after LDPC encoding is 3000 bits, BG2 may be selected, a total quantity of columns is 10, and Z=104. Because column weights of first T columns in BG2 are large, corresponding information bits are reliable, and are not prone to errors, polar code encoding does not need to be performed for additional protection. That is, bits that cause an LDPC error floor are mainly distributed at positions corresponding to column weights that are not large. For example, T is 2, column weights of a column 0 and a column 1 in BG2 are large, and bits corresponding to a column 2 to a column 9 (having column weights that are not large) are prone to errors. A quantity (K_B) of bits having large column weights is Z×2=208.

The Polar-LDPC encoding and decoding process 1 in FIG. 11 is as follows: The terminal device sequentially performs CRC24 encoding and polar code encoding on 792 bits. After CRC24 encoding is performed on the 792 bits, a length K_S_CRC of the bit sequence is 816 bits. After polar code encoding is performed on the 816 bits, a length N_polar of the bit sequence is 858 bits. Further, after the 208 bits and the 858 bits are concatenated (a length K_ldpc of the 208 bits and the 858 bits is 1066 bits), LDPC encoding and QPSK modulation are sequentially performed, and then information is sent to the network device through the AWGN channel. Correspondingly, after receiving the information, the network device sequentially performs demodulation and LOMS decoding on the information, to obtain bits on which polar code decoding needs to be performed. A length of the bits is K_ldpc-K_B=858 bits. Bits having large column weights, with a length of 208 bits, may be further obtained. In this way, Û may be obtained.

The Polar-LDPC encoding and decoding process 2 in FIG. 11 is as follows: The terminal device performs CRC24 encoding on information bits to obtain bits with a length K_CRC of 1024 bits. A length K_polar of a bit sequence on which polar code encoding needs to be performed is 816 bits, and a length K_B of a bit sequence on which polar code encoding does not need to be performed is 208 bits. Further, after polar code encoding is performed on the 816 bits, a length N_polar of the bit sequence is 858 bits. In this way, after the 208 bits and the 858 bits are concatenated (a length K_ldpc of the 208 bits and the 858 bits is 1066 bits), LDPC encoding and QPSK modulation are sequentially performed, and then information is sent to the network device through the AWGN channel. Correspondingly, after receiving the information, the network device sequentially performs demodulation and LOMS decoding on the information, to obtain bits on which polar code decoding needs to be performed. A length of the bits is K_ldpc-K_B=858 bits. Bits having large column weights, with a length of 208 bits, may be further obtained. In this way, Û may be obtained. In FIG. 11, iterations of LOMS decoding may be 15 or 25, polar code decoding may be SC decoding or SCL decoding, and a path width L may be 8. A length of Û is 1000 bits. In addition, the LDPC encoding and decoding process in FIG. 11 is similar to the LDPC encoding and decoding process in FIG. 9. Details are not described herein again.

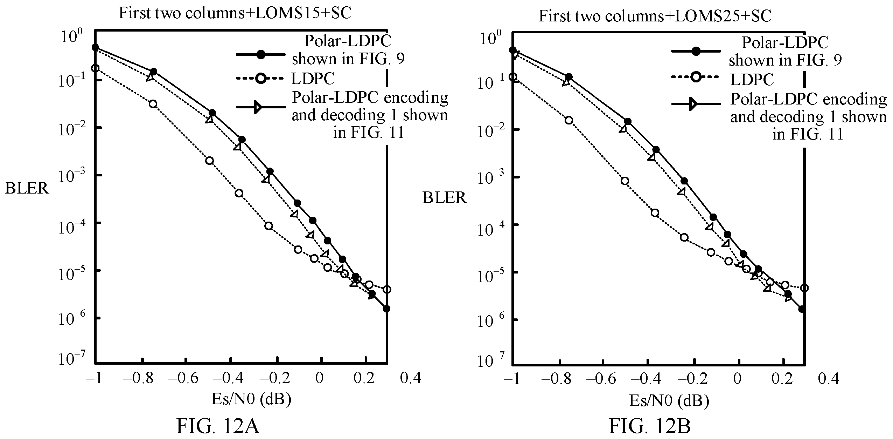

The following describes, based on the example shown in FIG. 11, beneficial effects of the encoding method shown in FIG. 7 and the decoding method shown in FIG. 8 with reference to FIG. 12A to FIG. 12D. Specifically, in FIG. 12A to FIG. 12D, horizontal coordinates represent SNRs, that is, Es/N0, and vertical coordinates represent BLERs.

In FIG. 12A, iterations of LOMS decoding are 15, and first two columns in BG2 have large column weights. A curve of Polar-LDPC shown in FIG. 9 represents BLER performance corresponding to the Polar-LDPC encoding and decoding process in FIG. 9. A curve of LDPC represents BLER performance corresponding to the LDPC encoding and decoding process in FIG. 11. A curve of Polar-LDPC shown in FIG. 11 represents BLER performance corresponding to the Polar-LDPC encoding and decoding process 1 in FIG. 11. It can be learned that, in a case in which the BLER is less than or equal to 8×10⁻⁶, error correction performance corresponding to the Polar-LDPC encoding and decoding shown in FIG. 9 and error correction performance corresponding to the Polar-LDPC encoding and decoding 1 in FIG. 11 may still decrease exponentially as the SNR increases, and there is no error floor.

In FIG. 12B, iterations of LOMS decoding are 25, and first two columns in BG2 have large column weights. A curve of Polar-LDPC shown in FIG. 9 represents BLER performance corresponding to the Polar-LDPC encoding and decoding process in FIG. 9. A curve of LDPC represents BLER performance corresponding to the LDPC encoding and decoding process in FIG. 11. A curve of Polar-LDPC shown in FIG. 11 represents BLER performance corresponding to the Polar-LDPC encoding and decoding process 1 in FIG. 11. It can be learned that, in a case in which the BLER is less than or equal to 10⁻⁵, error correction performance corresponding to the Polar-LDPC encoding and decoding shown in FIG. 9 and error correction performance corresponding to the Polar-LDPC encoding and decoding 1 in FIG. 11 may still decrease exponentially as the SNR increases, and there is no error floor.

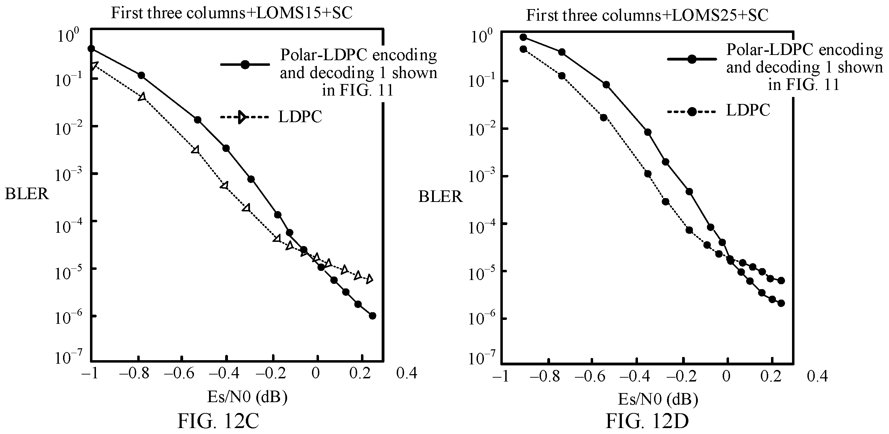

In FIG. 12C, iterations of LOMS decoding are 15, and first three columns in BG2 have large column weights. A curve of LDPC represents BLER performance corresponding to the LDPC encoding and decoding process in FIG. 11. A curve of Polar-LDPC shown in FIG. 11 represents BLER performance corresponding to the Polar-LDPC encoding and decoding process 1 in FIG. 11. It can be learned that, in a case in which the BLER is less than or equal to 10⁻⁵ , error correction performance corresponding to the Polar-LDPC encoding and decoding shown in FIG. 9 and error correction performance corresponding to the Polar-LDPC encoding and decoding 1 in FIG. 11 may still decrease exponentially as the SNR increases, and there is no error floor.

In FIG. 12D, iterations of LOMS decoding are 25, and first three columns in BG2 have large column weights. A curve of LDPC represents BLER performance corresponding to the LDPC encoding and decoding process in FIG. 11. A curve of Polar-LDPC shown in FIG. 11 represents BLER performance corresponding to the Polar-LDPC encoding and decoding process 1 in FIG. 11. It can be learned that, in a case in which the BLER is less than or equal to 10⁻⁵ , error correction performance corresponding to the Polar-LDPC encoding and decoding shown in FIG. 9 and error correction performance corresponding to the Polar-LDPC encoding and decoding 1 in FIG. 11 may still decrease exponentially as the SNR increases, and there is no error floor.

In addition, FIG. 12A is compared with FIG. 12C, or FIG. 12B is compared with FIG. 12D. In FIG. 12C and FIG. 12D, polar code encoding is not performed on information bits corresponding to the first three columns having large column weights, so that redundant bits introduced by polar outer code are further reduced, a loss of waterfall region performance is reduced from 0.2 dB to about 0.1x dB, and the waterfall region performance is improved.

It can be understood that, to implement the foregoing functions, the devices include corresponding hardware structures and/or software modules for executing the functions. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the terminal device or the network device may be divided into functional modules based on the foregoing method examples. For example, each functional module may be obtained through division based on a corresponding function, or two or more functions may be integrated into one processing module. The integrated module may be implemented in a form of hardware, or may be implemented in a form of software functional module. It should be noted that, in embodiments of this application, module division is an example, and is merely a logical function division. In actual implementation, another division manner may be used.

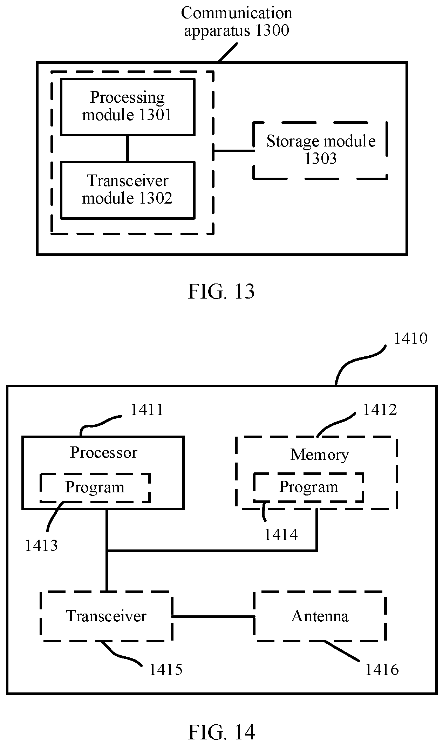

FIG. 13 is a diagram of a structure of a communication apparatus according to an embodiment of this application. The communication apparatus 1300 may be applied to the methods in any one of embodiments shown in FIG. 5 to FIG. 8. As shown in FIG. 13, the communication apparatus 1300 includes a processing module 1301 and a transceiver module 1302. The processing module 1301 may be one or more processors, and the transceiver module 1302 may be a transceiver or a communication interface. The communication apparatus may be configured to implement functions of the terminal device or the network device in any one of the foregoing method embodiments, or configured to implement functions of a network element in any one of the foregoing method embodiments. The network element or network function may be network elements in a hardware device, software functions running on dedicated hardware, or virtualized functions instantiated on a platform (for example, a cloud platform). Optionally, the communication apparatus 1300 may further include a storage module 1303, configured to store program code and data of the communication apparatus 1300.

In an instance, when the communication apparatus is used as a terminal device or a chip used in the terminal device, and performs the steps performed by the terminal device in the foregoing method embodiments, the transceiver module 1302 is specifically configured to perform a sending and/or receiving action performed by the terminal device in any one of embodiments in FIG. 5 to FIG. 8, for example, support the terminal device in performing another process of the technology described in this specification; and the processing module 1301 may be configured to support the communication apparatus 1300 in performing a processing action in the foregoing method embodiments, for example, support the terminal device in performing another process of the technology described in this specification.

For example, the processing module 1301 is configured to determine a second bit sequence and a third bit sequence based on a first bit sequence, where the third bit sequence includes a bit sequence whose weight is higher than a first threshold in a base graph corresponding to the first bit sequence; perform polar code encoding on the second bit sequence to obtain a fourth bit sequence; and perform low-density parity-check LDPC encoding on the third bit sequence and the fourth bit sequence to obtain a fifth bit sequence.

In a possible implementation, when the determining the second bit sequence and the third bit sequence based on the first bit sequence, the processing module 1301 is configured to determine a first value based on a first quantity of columns whose weight is higher than the first threshold in the base graph; determine the third bit sequence from the first bit sequence based on the first value and a lifting factor corresponding to the first bit sequence; and determine the second bit sequence based on the third bit sequence and the first bit sequence.

In a possible implementation, when the determining the first value based on the first quantity of columns whose weight is higher than the first threshold in the base graph, the processing module 1301 is configured to determine a second quantity of columns having highest reliability from columns other than the columns whose weights are higher than the first threshold in the base graph; and determine the first value based on the first quantity of columns and the second quantity of columns.

In a possible implementation, when the performing polar code encoding on the second bit sequence to obtain the fourth bit sequence, the processing module 1301 is configured to perform check coding on the second bit sequence to obtain a sixth bit sequence; and perform polar code encoding on the sixth bit sequence to obtain the fourth bit sequence.

In a possible implementation, the processing module 1301 is further configured to perform check coding on the sixth bit sequence to obtain the first bit sequence.

In a possible implementation, the processing module 1301 is further configured to segment an initial bit sequence based on a first segment length to obtain X bit sequences, where the X bit sequences include the first bit sequence or a seventh bit sequence, and X is an integer greater than 1, where the first segment length is determined based on the first value and the lifting factor.

In a possible implementation, when the determining the second bit sequence based on the third bit sequence and the first bit sequence, the processing module 1301 is configured to segment, based on a second segment length, a bit sequence other than the third bit sequence in the first bit sequence, to obtain Y bit sequences, where the Y bit sequences include the second bit sequence, and Y is an integer greater than 1, where the second segment length is determined based on a maximum length supported by polar code encoding and a third value.

In a possible implementation, the transceiver module 1302 is further configured to send a symbol sequence based on the third bit sequence.

In an instance, when the communication apparatus is used as a network device or a chip used in the network device, and performs the steps performed by the network device in the foregoing method embodiments, the transceiver module 1302 is specifically configured to perform a sending and/or receiving action performed by the network device in any one of embodiments in FIG. 5 to FIG. 8, for example, support the network device in performing another process of the technology described in this specification; and the processing module 1301 may be configured to support the communication apparatus 1300 in performing a processing action in the foregoing method embodiments, for example, support the network device in performing another process of the technology described in this specification.

For example, the processing module 1301 is configured to obtain a symbol sequence; determine a fifth bit sequence based on the symbol sequence; perform LDPC decoding on the fifth bit sequence to obtain a third bit sequence and a fourth bit sequence; perform polar code decoding on the fourth bit sequence to obtain a second bit sequence; and determine a first bit sequence based on the third bit sequence and the second bit sequence.

In a possible implementation, when the terminal device or the network device is a chip, the transceiver module 1302 may be a communication interface, a pin, a circuit, or the like. The communication interface may be configured to input data to be processed to a processor, and may output a processing result of the processor to the outside. During specific implementation, the communication interface may be a general-purpose input/output (general purpose input/output, GPIO) interface, and may be connected to a plurality of peripheral devices (for example, a liquid crystal display (LCD), a camera (camera), a radio frequency (radio frequency, RF) module, and an antenna). The communication interface is connected to the processor through a bus.

The processing module 1301 may be a processor. The processor may execute computer-executable instructions stored in the storage module, so that the chip performs the method in any one of embodiments shown in FIG. 5 to FIG. 8. Further, the processor may include a controller, an arithmetic logic unit, and a register. For example, the controller is mainly responsible for instruction decoding, and transmitting a control signal for an operation corresponding to the instructions. The arithmetic unit is mainly responsible for performing a fixed-point or floating-point arithmetic operation, a shift operation, a logic operation, and the like, and may also perform an address operation and address translation. The register is mainly responsible for saving a quantity of register operations, intermediate operation results, and the like that are temporarily stored during instruction execution. During specific implementation, a hardware architecture of the processor may be an ASIC architecture, a microprocessor without interlocked piped stages (microprocessor without interlocked piped stages architecture, MIPS) architecture, an advanced reduced instruction set computer machines (advanced RISC machines, ARM) architecture, a second processor (network processor, NP) architecture, or the like. The processor may be a single-core or multi-core processor. The storage module may be a storage module in the chip, for example, a register or a cache. Alternatively, the storage module may be a storage module that is located outside the chip, for example, a ROM or another type of static storage device that can store static information and instructions, or a RAM.

It should be noted that a function corresponding to each of the processor and the interface may be implemented by a hardware design, may be implemented by a software design, or may be implemented by a combination of software and hardware. This is not limited herein.

FIG. 14 is a diagram of a structure of another communication apparatus according to an embodiment of this application. It may be understood that the communication apparatus 1410 includes means in necessary forms, such as modules, units, elements, circuits, or interfaces, which are appropriately configured together to execute the solution. The communication apparatus 1410 may be the foregoing terminal device or network device, or may be a component (for example, a chip) in these devices, to implement the method described in the foregoing method embodiments. The communication apparatus 1410 includes one or more processors 1411. The processor 1411 may be a general-purpose processor, a dedicated processor, or the like. For example, the processor may be a baseband processor or a central processing unit. The baseband processor may be configured to process a communication protocol and communication data. The central processing unit may be configured to control the communication apparatus (for example, the terminal device, the network device, or the chip), to execute a software program and process data of the software program.

Optionally, in a design, the processor 1411 may include a program 1413 (which sometimes may also be referred to as code or instructions). The program 1413 may be executed by the processor 1411, to enable the communication apparatus 1410 to perform the method described in the foregoing embodiments. In another possible design, the communication apparatus 1410 includes a circuit (not shown in FIG. 14). The circuit is configured to implement functions such as the terminal device and the network device in the foregoing embodiments. Optionally, the communication apparatus 1410 may include one or more memories 1412, and a program 1414 (which sometimes may also be referred to as code or instructions) is stored in the memory 1412. The program 1414 may be executed by the processor 1411, to enable the communication apparatus 1410 to perform the method described in the foregoing method embodiments. Optionally, the processor 1411 and/or the memory 1412 may further store data. The processor and the memory may be separately disposed, or may be integrated together.

Optionally, the communication apparatus 1410 may further include a transceiver 1415 and/or an antenna 1416. The processor 1411 may also be referred to as a processing unit sometimes, and controls the communication apparatus (for example, the terminal device or the network device). The transceiver 1415 sometimes may also be referred to as a transceiver unit, a transceiver machine, a transceiver circuit, a transceiver, or the like, and is configured to implement a transceiver function of the communication apparatus through the antenna 1416.

An embodiment of this application further provides a communication apparatus. The communication apparatus includes at least one processor. The at least one processor is configured to perform the method according to any one of the embodiments in FIG. 5 to FIG. 8.

An embodiment of this application further provides a computer-readable storage medium. The computer-readable storage medium stores computer instructions. When the computer instructions are executed, a computer is caused to perform the method according to any one of the embodiments in FIG. 5 to FIG. 8.

An embodiment of this application further provides a computer program product. The computer program product includes computer program code. When the computer program code is run by a computer, the computer is caused to perform the method according to any one of the embodiments in FIG. 5 to FIG. 8.

An embodiment of this application further provides a chip. The chip includes at least one processor and an interface. The processor is configured to read and execute instructions stored in a memory. When the instructions are run, the chip is caused to perform the method according to any one of the embodiments in FIG. 5 to FIG. 8.

The foregoing units described as separate components may or may not be physically separate, and components displayed as units may or may not be physical units, may be located in one position, or may be distributed on a plurality of network units. A part or all of the units may be selected based on actual requirements to achieve the objectives of the solutions of embodiments of this application. In addition, various network element units in embodiments of this application may be integrated into one processing unit, each of the units may exist alone physically, or two or more units may be integrated into one unit. The integrated unit may be implemented in a form of hardware, or may be implemented in a form of a software network element unit.

When the integrated unit is implemented in the form of the software network element unit and sold or used as an independent product, the integrated unit may be stored in a computer-readable storage medium. Based on such an understanding, a part that essentially contributes to the technical solutions of this application or all or a part of the technical solutions may be embodied in a form of a software product. The computer software product is stored in a storage medium, and includes several instructions for enabling a computer device (which may be a personal computer, a terminal device, a cloud server, a network device, or the like) to perform all or a part of steps of the foregoing methods in embodiments of this application. The foregoing storage medium includes any medium that can store program code, for example, a USB flash drive, a removable hard disk drive, a read-only memory (ROM, Read-Only Memory), a random access memory (RAM, Random Access Memory), a magnetic disk, or an optical disk. The foregoing descriptions are merely specific embodiments of this application, but are not intended to limit the protection scope of this application. Any modification or replacement readily figured out by a person skilled in the art within the technical scope disclosed in this application shall fall within the protection scope of this application. Therefore, the protection scope of this application shall be subject to the protection scope of the claims.

## Claims

1. An encoding method, comprising:
determining a second bit sequence and a third bit sequence based on a first bit sequence, wherein the third bit sequence comprises a bit sequence whose weight is higher than a first threshold in a base graph corresponding to the first bit sequence;
performing polar code encoding on the second bit sequence to obtain a fourth bit sequence; and
performing low-density parity-check LDPC encoding on the third bit sequence and the fourth bit sequence to obtain a fifth bit sequence.

2. The method according to claim 1, wherein the determining the second bit sequence and the third bit sequence based on the first bit sequence comprises:
determining a first value based on a first quantity of columns whose weights are higher than the first threshold in the base graph;
determining the third bit sequence from the first bit sequence based on the first value and a lifting factor corresponding to the first bit sequence; and
determining the second bit sequence based on the third bit sequence and the first bit sequence.

3. The method according to claim 1 or 2, wherein the first quantity of columns is an integer greater than or equal to 1.

4. The method according to any one of claims 1 to 3, wherein the determining the first value based on the first quantity of columns whose weight is higher than the first threshold in the base graph comprises:
determining, from among columns other than the columns whose weights are higher than the first threshold in the base graph, a second quantity of columns having highest reliability; and
determining the first value based on the first quantity of columns and the second quantity of columns.

5. The method according to any one of claims 1 to 4, wherein the performing polar code encoding on the second bit sequence to obtain the fourth bit sequence comprises:
performing check coding on the second bit sequence to obtain a sixth bit sequence; and
performing polar code encoding on the sixth bit sequence to obtain the fourth bit sequence.

6. The method according to any one of claims 1 to 4, wherein the method further comprises:
performing check coding on a seventh bit sequence to obtain the first bit sequence.

7. The method according to any one of claims 1 to 6, wherein the method further comprises:
segmenting an initial bit sequence based on a first segment length to obtain X bit sequences, wherein the X bit sequences comprise the first bit sequence or the seventh bit sequence, and X is an integer greater than 1, wherein
the first segment length is determined based on the first value and the lifting factor.

8. The method according to claim 7, wherein that the first segment length is determined based on the first value and the lifting factor comprises:
the first segment length is determined based on the first value, the lifting factor, and a second value, wherein the second value is determined based on a total quantity of columns in the base graph and the first value.

9. The method according to claim 7 or 8, wherein
the first segment length meets the following condition: $K 1 = \left⌈\left(a+b\times R\right)\times Z\right⌉$, wherein
a is the first value, b is the second value, R is a third value, and Z is the lifting factor.

10. The method according to any one of claims 1 to 9, wherein the determining the second bit sequence based on the third bit sequence and the first bit sequence comprises:
segmenting, based on a second segment length, a bit sequence other than the third bit sequence in the first bit sequence, to obtain Y bit sequences, wherein the Y bit sequences comprise the second bit sequence, and Y is an integer greater than 1, wherein
the second segment length is determined based on a maximum length supported by polar code encoding and the third value.

11. The method according to claim 10, wherein
the second segment length meets the following condition: $K 2 = \left⌈Nm\times R\right⌉$, wherein
Nm is the maximum length supported by polar code encoding, and R is the third value.

12. A communication apparatus, comprising a unit or a module configured to implement the method according to any one of claims 1 to 11.

13. A communication apparatus, wherein the communication apparatus comprises at least one processor, and the at least one processor is configured to perform the method according to any one of claims 1 to 11.

14. A computer-readable storage medium, wherein the computer-readable storage medium stores computer instructions, and when the computer instructions are executed, the computer is caused to perform the method according to any one of claims 1 to 11.

15. A computer program product, wherein the computer program product comprises computer program code, and when the computer program code is executed by a computer, the computer is caused to perform the method according to any one of claims 1 to 11.

16. A chip, wherein the chip comprises at least one processor and an interface, the processor is configured to read and execute instructions stored in a memory, and when the instructions are run, the chip is caused to perform the method according to any one of claims 1 to 11.
